Europäisches Patentamt

(19) European Patent Office  (11) Numéro de publication: **0 252 542**

Office européen des brevets  **B1**

(12)  **FASCICULE DE BREVET EUROPEEN**

(45) Date de publication du fascicule du brevet: **19.12.90**  (51) Int. Cl.⁵: **H 05 B 6/78**

(21) Numéro de dépôt: **87201017.8**

(22) Date de dépôt: **01.06.87**

(54) **Dispositif modulaire pour l'application de micro-ondes en vue notamment du chauffage, sechage ou torrefaction d'un materiau.**

(30) Priorité: **06.06.86 FR 8608332**

(43) Date de publication de la demande:
**13.01.88 Bulletin 88/02**

(45) Mention de la délivrance du brevet:
**19.12.90 Bulletin 90/51**

(84) Etats contractants désignés:
**BE CH DE ES FR GB IT LI NL**

(56) Documents cités:
**EP-A-0 136 453**
**FR-A-1 471 131**
**FR-A-2 410 803**
**GB-A-1 092 861**
**GB-A-1 482 755**
**US-A-3 535 482**
**US-A-3 673 370**

(73) Titulaire: **UNIVERSITE DE BORDEAUX I**
**Etablissement public à caractère scientifique, culturel et professionnel**
**351 cours de la Libération**
**F-33405 Talence Cédex (FR)**

(72) Inventeur: **Marzat, Claude**
**1 rue Edison**
**F-33400 Talence (FR)**
Inventeur: **Decourt, Rodolphe**
**9 rue du Paradis**
**F-33850 Leognan (FR)**
Inventeur: **Duport, Bernadette Résidence Grand Louis**
**Bât. F-Appt 14 Avenue de l'Hippodrome**
**F-33320 Eysines (FR)**

(74) Mandataire: **Barre, Philippe**
**Cabinet Barre-Gatti-Laforgue 95 rue des Amidonniers**
**F-31069 Toulouse Cédex (FR)**

Courier Press, Leamington Spa, England.

## Description

L'invention concerne un dispositif pour l'application de micro-ondes en vue du traitement d'un matériau. Elle s'applique en particulier aux matériaux se présentant sous forme divisée (poudres, matériaux granulaires, copeaux, ...) ou, le cas échéant, sous forme liquide. Le dispositif visé par l'invention peut être utilisé pour des traitements divers: chauffage (cuisson, stérilisation, pasteurisation, désinsectisation, polymérisation...), séchage, torréfaction.... Le terme "traitement" doit être entendu au sens le plus large, le dispositif pouvant éventuellement être utilisé en métrologie pour la mesure des caractéristiques d'un matériau (mesure d'humidité, mesure de constantes diélectriques...). Par le terme "micro-ondes", il convient d'entendre des ondes électromagnétiques de fréquence dans le vide F comprise entre 0,1 et 30 gigahertz, en particulier fréquences industrielles, scientifiques et médicales ("ISM").

L'application de micro-ondes à un matériau se présentant sous forme divisée est généralement réalisée dans des fours tunnels dans lesquels le matériau est amené à défiler. Par exemple, le brevet FR 2 327 700 vise une installation de ce type pour le traitement en continu de produits alimentaires. Toutefois, ces installations sont complexes, onéreuses et souvent très encombrantes.

D'autres techniques ont également été proposées pour effectuer des traitements micro-ondes. Certaines mettent en oeuvre des applicateurs formés par des juxtapositions ou combinaisons particulières de guides d'ondes dans lesquels sont placés les produits à traiter (brevet FR 2 500 707, FR 2 478 930...), mais ces dispositifs sont mal adaptés au traitement de produits se présentant sous forme divisée. D'autres visent des dispositifs plus particulièrement destinés au traitement de produits granulaires, tels que le brevet FR 2 519 224 qui décrit un applicateur rotatif alimenté en micro-ondes à travers son arbre de rotation, lequel est muni à cet effet d'un canal coaxial, ou le brevet FR 2 458 772 qui décrit un dispositif formé par un guide d'ondes s'étendant dans le sens vertical avec une circulation par gravité des produits dans celui-ci. Toutefois, ces dispositifs connus présentent des défauts résidant, soit dans leur complexité (applicateur rotatif), soit dans leur fonctionnement nécessairement discontinu (applicateur rotatif), soit dans la répartition très hétérogène du champ qui conduit à des traitements peu uniformes (guide d'ondes vertical), soit encore dans leur manque de souplesse pour appliquer les micro-ondes avec un bon rendement à des types de produits différents (guide d'ondes vertical).

Par ailleurs, les brevets GB no. 1 482 755 et FR no. 2 410 803 décrivent des dispositifs applicateurs de micro-ondes, qui possèdent un certain caractère modulaire: des modules formant des cavités résonnantes sont alignés selon un axe pour former une colonne de traitement; toutefois, ces dispositifs qui fonctionnent sur le mode fondamental (TM$_{010}$), soit au moyen d'organes d'accords, soit grâce à des antennes rayonnantes disposées dans les cavités, présentent des défauts. En premier lieu, ils sont le siège d'une résonance très pointue qui doit être ajustée de façon très précise en fonction des produits traités et de leurs caractéristiques. Ainsi, pour des produits amenés à évoluer pendant le traitement (séchage par exemple), les divers modules doivent chacun être réglés de façon différente sous peine d'avoir un rendement énergétique très hétérogène et donc un traitement très hétérogène. De plus, le même module ne peut être utilisé pour traiter des produits de nature différente (ayant des perméabilités magnétiques très différentes). En conséquence, de tels dispositifs ne bénéficient pas d'une modularité réelle, permettant d'ajouter sans réglage particulier des modules les uns à la suite des autres pour obtenir un traitement d'intensité désiré d'un produit donné.

La présente invention se propose de fournir un dispositif modulaire d'application des micro-ondes, combinant un grand nombre de qualités essentielles en pratique:

grande simplicité structurelle (absence de pièces en mouvement, absence de piège à ondes ou de sas contre les fuites) conduisant à une robustesse remarquable permettant de l'utiliser dans des environnements sévères,

excellente homogénéité du champ conduisant à des traitements uniformes,

haut rendement,

réelle qualité de polyvalence, permettant de traiter un grand nombre de produits absorbants des micro-ondes,

souplesse d'utilisation provenant en particulier de sa modularité (possibilité d'ajouter des modules standards sans perturber le champ électrique),

possibilité de fonctionnement en continu, semi-continu ou discontinu.

Le dispositif d'application de micro-ondes visé par l'invention est défini en se référant à l'art antérieur formé par les brevets GB no. 1 482 755 et FR no. 2 410 803 déjà évoqués. Il comprend plusieurs modules alignés en vue de former une colonne de traitement, chaque module constituant une cavité résonnante et comportant les moyens suivants se retrouvant en tant que tels dans l'art antérieur: deux flasques circulaires en regard en un matériau électriquement conducteur, des ouvertures centrales ménagées en regard dans lesdits flasques pour le passage du matériau à traiter, une paroi sensiblement cylindrique en un matériau électriquement conducteur reliant ces flasques de façon à former une boîte fermée de diamètre interne D, une lumière ménagée dans ladite paroi cylindrique en vue de l'alimentation de la cavité en micro-ondes, et un tronçon externe de guide d'ondes, couplé à la cavité résonnante au niveau de ladite lumière et adapté pour être relié à une source de micro-ondes de fréquence F prédéterminée correspondant à une longueur d'onde λ dans le vide.

Le dispositif conforme à l'invention est caractérisé en ce que:

la cavité résonnante est dimensionnée de façon à résonner dans le vide selon le mode $TM_{020}$, son diamètre D exprimé en centimètres étant sensiblement compris entre

$$\frac{50}{F} \text{ et } \frac{75}{F},$$

où F est exprimé en gigahertz,

les ouvertures des flasques sont dimensionnées de façon que soit conservée sensiblement la distribution du champ électrique précitée, le diamètre -d- de chacune desdites ouvertures étant tel que le bord circulaire de chaque ouverture coïncide approximativement avec un noeud du champ électrique en cours de fonctionnement,

les modules sont extérieurement munis de manchons d'assemblage situés autour des ouvertures de leurs flasques, lesdits manchons étant adaptés pour permettre d'assujettir lesdits modules les uns aux autres avec un écartement propre à assurer un découplage entre cavités résonnantes voisines en cours de fonctionnement.

Un tel dispositif possède une structure modulaire extrêmement simple puisqu'il est essentiellement constitué par un empilement de boîtes assemblées les unes aux autres. On a pu constater que le traitement demeurait homogène pour une grande variété de matériaux et ce, sans avoir à effectuer de réglage ou à modifier les modules. Les expérimentations ont démontré que, dans la plupart des cas, le mode $TM_{020}$ pour lequel les caractéristiques du dispositif sont définies à vide se transformait en modes $TM_{120}$ ou $TM_{220}$ lorsqu'un matériau absorbant était disposé dans les cavités. Ces modes de fonctionnement $TM_{120}$ et $TM_{220}$ donnent une résonance qui est peu influencée par les caractéristiques du matériau et permet une bonne homogénéité de distribution énergétique quelle que soit la nature du matériau absorbant ou son état, sans problème d'accord ni de couplage. Dans certains cas (beaucoup plus rare), le mode $TM_{020}$ est conservé lorsque la cavité contient un matériau très peu absorbant, ce mode de résonance étant, lui aussi, peu sensible aux caractéristiques du matériau. De plus, dans le dispositif de l'invention, il est facile d'adapter le nombre de cavités résonnantes au traitement désiré et à l'application envisagée sans perturber le champ dans chaque cavité, puisque, d'une part, leur résonance est peu liée à l'état du matériau et que, d'autre part, chacune d'elles est découplée de ses voisines. En conclusion, un tel dispositif permet de réaliser un couplage énergétique optimal pour une grande variété de matériaux, et un traitement homogène adapté à l'application envisagée.

Il est à noter que la condition concernant le diamètre -d- des ouvertures des flasques possède deux conséquences essentielles: d'une part, elle contribue à permettre l'établissement des modes $TM_{020}$, $TM_{120}$ ou $TM_{220}$ à l'intérieur de chaque cavité, d'autre part, elle assure la coupure de ces modes (et des modes $TM_{110}$ et $TM_{210}$) dans les ouvertures et, donc, dans les manchons d'assemblage, de sorte que le découplage peut être obtenu avec une longueur relativement faible desdites manchons. En pratique, les manchons d'assemblage seront prévus de façon que leur longueur soit au moins égale à $\lambda/4$, afin d'assurer un découplage effectif entre cavité pour tous les matériaux absorbants susceptibles d'être traités.

En outre, les manchons d'assemblages sont avantageusement agencés de façon à permettre d'assujettir deux modules voisins dans plusieurs positions angulaires l'un par rapport à l'autre. Ainsi, les divers modules de la colonne peuvent être assemblés avec des décalages angulaires les uns par rapport aux autres de façon à conduire à une répartition globale du champ assurant une bonne homogénéité du traitement.

Selon un mode de réalisation adapté au traitement d'un matériau se présentant sous forme divisée ou liquide, le dispositif comprend un tube de circulation du matériau, transparent aux micro-ondes et passant à travers les ouvertures des flasques, de façon à s'étendre sur toute la hauteur de la colonne de traitement formée par les modules. Cette colonne est de préférence disposée le long d'un axe très approximativement vertical en vue d'autoriser une circulation par gravité du matériau dans le tube de circulation.

L'invention s'applique au traitement d'un grand nombre de matériau ayant des propriétés de réactivité à l'égard des micro-ondes: matériau agroalimentaire (torréfaction des noisettes, du cacao, des amandes, des cacahuètes, du café, séchage du maïs, . . .) ou autres.

D'autres caractéristiques, buts et avantages de l'invention ressortiront de la description qui suit en référence aux dessins annexés, lesquels en présentent à titre d'exemples non limitatifs un mode de réalisation et une variante; sur ces dessins qui font partie intégrante de la présente description:

la figure 1 est une vue en perspective d'un module conforme à l'invention,

la figure 2 en est une coupe par un plan axial,

la figure 3 est une vue en perspective schématique d'un dispositif de traitement réalisé à partir de plusieurs modules,

la figure 4 est une coupe partielle dudit dispositif par un plan vertical axial,

les figures 5a et 5b sont des schémas illustrant la répartition du champ électrique dans une cavité, respectivement dans le mode de fonctionnement $TM_{020}$ et dans les modes $TM_{120}$ ou $TM_{220}$,

la figure 6 est une coupe schématique d'une variante.

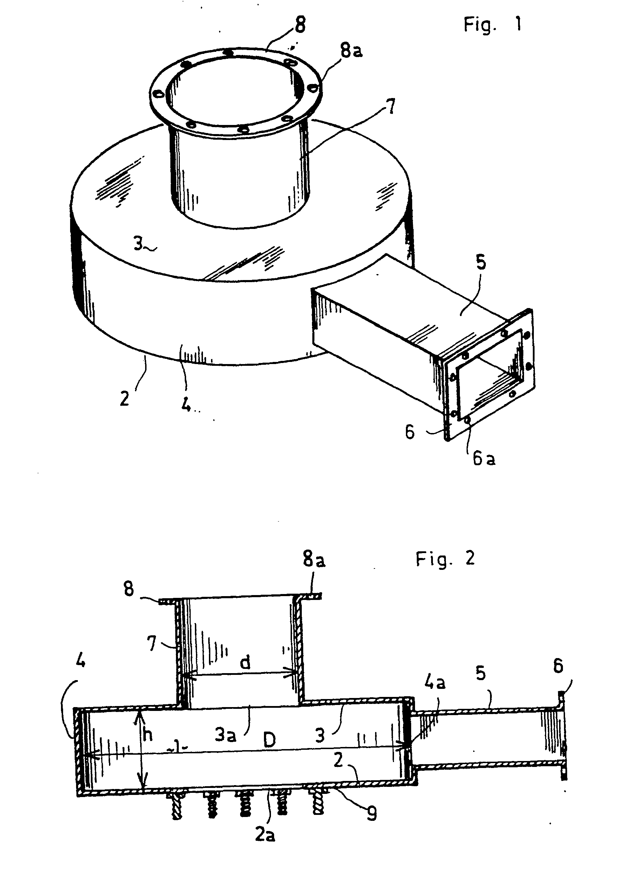

Le dispositif modulaire d'application de micro-ondes visé par l'invention comprend une superposition de plusieurs modules, en l'exemple chacun identique, du type de celui représenté aux figures 1 et 2.

Ce module comprend une cavité résonnante 1 formée par une boîte fermée en acier inoxydable, délimitée par deux flasques circulaires plats 2 et 3 qui sont situés en regard et par une paroi périphérique cylindrique 4 qui s'étend sur tout le pourtour des flasques et est soudée sur ceux-ci. Le diamètre D exprimé en centimètres de ladite boîte est prévu égal à 63/F (F fréquence exprimée en gigahertz).

En une zone de son pourtour, la paroi périphérique 4 est dotée d'une lumière 4a en l'exemple de forme rectangulaire, par laquelle un tronçon de guide d'ondes 5, de section rectangulaire, est couplé à la cavité résonnante 1. Ce tronçon de guide est pourvu à son extrémité d'une bride 6 portant des trous d'assemblage 6a, en vue de permettre de relier ledit tronçon à une source de micro-ondes. Le tronçon 5 possède une section rectangulaire adaptée à la longueur d'onde λ de ladite source. La lumière 4a présente une forme correspondant à cette section de façon que le guide 5 s'ouvre directement dans la cavité résonnante 1, sensiblement par toute sa section. La hauteur h de la cavité est au moins égale à la hauteur du guide 5. Cette hauteur h n'est pas critique en pratique et peut être ajustée en fonction de la densité de puissance à appliquer aux produits à traiter.

En outre, les flasques 2 et 3 sont percés, en leur centre, d'ouvertures 2a et 3a qui en l'exemple sont de forme circulaire. Le diamètre -d- de chaque ouverture est prévu égal à $d = D - 1,4\lambda$ car, dans ce cas, le guide d'onde 5 a une longueur d'onde de coupure voisine de la longueur d'onde guidée qu'il propage. (En pratique, dans ce cas, on dimensionne les ouvertures de façon à ne pas s'écarter de plus de $\mp 10\%$ de cette valeur).

Le flasque 3 est équipé autour de son ouverture 3a d'un manchon externe 7, en l'exemple de section circulaire, qui présente une longueur suffisante pour assurer un découplage de deux modules séparés par ledit manchon. Cette longueur sera en pratique supérieure à λ/4. Ce manchon est doté à son extrémité d'une bride 8 comportant des trous d'assemblage 8a; ces trous sont régulièrement répartis autour de la bride, par exemple huit trous angulairement distants de 45°.

Le flasque 2 est doté autour de son ouverture 2a de moyens d'assemblage tels que goujons 9 extérieurement soudés sur ledit flasque; ces goujons sont régulièrement répartis autour de ladite ouverture 2a pour pouvoir venir coopérer avec les trous 8a de la bride d'un autre module. En l'exemple précité, ces goujons sont au nombre de huit, angulairement distants de 45°.

Il est ainsi possible d'assembler les modules au moyen des goujons 9, avec un décalage angulaire ajustable de n.45° (0≤n<8).

La cavité résonnante 1 formée par la boîte 2, 3, 4 est dimensionnée de façon à résonner dans le vide sur le mode $TM_{020}$; les ouvertures 2a, 3a des flasques sont dimensionnées de façon que soit conservé sans perturbation très sensible cette distribution du champ électrique. Par exemple, dans le cas de micro-ondes de fréquence égale à 2450 MHz, ces dimensions sont les suivantes: diamètre interne de la cavité:

$$D = \frac{63}{F} = 25,6 \text{ cm,}$$

longueur du manchon 7: 4 cm,
section intérieure du tronçon de guide d'ondes 6: 4,3×8,6 cm,
diamètre des ouvertures 3a et 4a:

$$d = D - 1,4\lambda = 8,45 \text{ cm.}$$

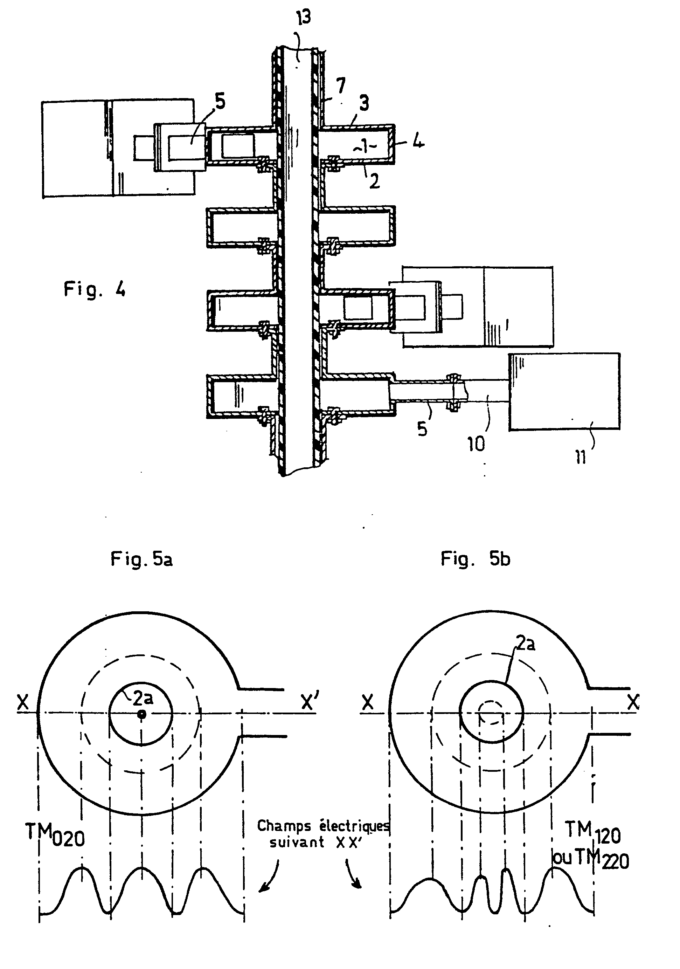

La figure 5a schématise la distribution du champ électrique en mode $TM_{020}$ (fonctionnement supposé dans le vide ou pour de rares matériaux très peu absorbants). Il est à remarquer que le bord circulaire de chaque ouverture 2a ou 3a correspond à peu près à un noeud du champ électrique. Lorsqu'on dispose un matériau dans la cavité, ce mode se transforme le plus souvent en modes $TM_{120}$ ou $TM_{220}$ schématisés à la figure 5b. Dans ce cas également, le bord des ouvertures 2a et 3a coïncide approximativement avec un noeud du champ électrique; ce mode de résonance constitue le cas général, comme l'ont démontré les expérimentations sur divers types de matériaux. Les deux modes de résonance ci-dessus sont amortis, et la répartition énergétique demeure à peu près uniforme pour une très large gamme de permittivité diélectrique du matériau, sans réglage particulier.

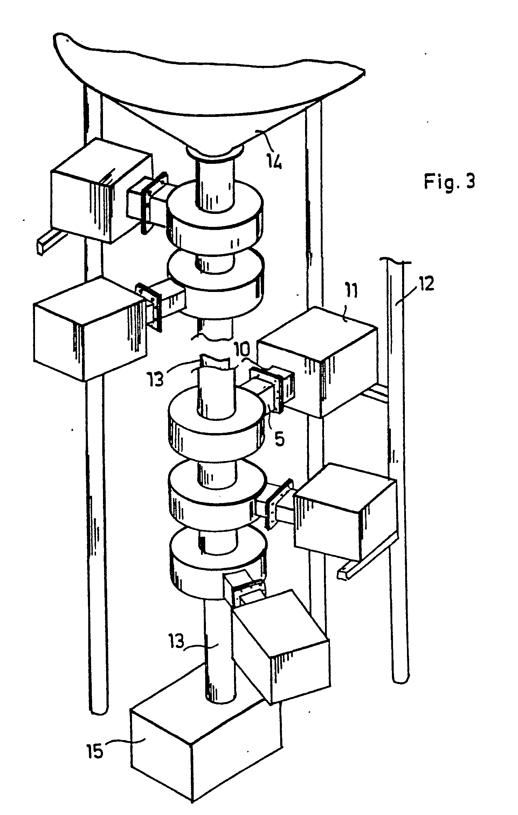

Les modules ci-dessus décrits peuvent être assemblés en positions superposées pour former une colonne de traitement s'étendant le long d'un axe sensiblement vertical, comme le schématisent les figures 3 et 4.

Dans les exemples de transfert énergétiques fournis plus loin, le dispositif utilisé comportait 16 modules ainsi superposés, leur assemblage étant réalisé avec un décalage angulaire de 45° d'un module par rapport au module voisin. La distance entre plans de symétrie de modules était de 8,5 cm. La hauteur de chaque cavité étant légèrement supérieure à celle du tronçon 5 (4,5 cm).

Le tronçon de guide d'ondes 5 de chaque module est relié par un guide d'ondes intermédiaire tel que 10 à un générateur de micro-ondes 11 de puissance éventuellement réglable. Les divers générateurs 11 et les modules sont assujettis à un bâti métallique 12 qui porte l'ensemble.

En outre, un tube 13 de circulation du matériau à traiter est disposé selon l'axe des modules, de façon à traverser ceux-ci par leurs ouvertures 2a, 3a. Ce tube est réalisé en un matériau transparent aux micro-ondes. En cet exemple, ce tube est étanche. En partie haute, une trémie 14 assure l'alimentation continue de celui-ci en matériau à traiter, cependant qu'en partie basse, le tube est équipé d'un système classique de régulation du débit de matériau s'écoulant par gravité (système symbolisé en 15). Le cas échéant, ce système peut être jumelé avec un système d'aspiration des vapeurs ou un système d'aération, ou encore un système de récupération de la chaleur émise par le produit, les générateurs et leur alimentation.

Il est à noter que le tube interne 13 peut le cas échéant permettre de travailler à une pression autre que la pression atmosphérique.

La colonne ci-dessus décrite a été utilisée pour réaliser des mesures de rendement de transfert énergétiques dans le cas de plusieurs produits granulaires ou liquides; les résultats suivants ont été obtenus:

| Produits | Rendement |
|----------|-----------|
| Eau | 97% |
| Maïs à 10% $H_2O$ | 97% |
| Maïs sec | 75% |
| Noisettes à 5% $H_2O$ | 97% |
| Noisettes à 1,5% $H_2O$ | 95% |
| Sable à 1% $H_2O$ | 96% |

Le dispositif visé par l'invention se démarque des dispositifs antérieurs par un ensemble de qualités qu'il associe: modularité lui conférant une grande souplesse d'utilisation, haut rendement, homogénéité du traitement, simplicité structurelle conduisant à un faible coût, à une robustesse remarquable et à une grande facilité d'entretien, caractère peu critique facilitant sa fabrication, polyvalence, faible niveau de fuites (sans sas ni pièges à ondes particuliers), facilité d'adaptation à des processus de fonctionnement continu, semi-continu ou discontinu . . . .

Par ailleurs, il est souvent souhaitable de soumettre un produit à une densité de puissance décroissante au fur et à mesure de son traitement (notamment dans le cas d'un séchage pour éviter de brûler le produit lorsqu'il se trouve presque sec). Dans ce cas, il suffit, soit de régler la puissance des générateurs 11, soit de prévoir des cavités dont la hauteur croisse d'amont en aval, depuis le début du traitement jusqu'à la fin. Bien entendu, plusieurs colonnes de traitement peuvent le cas échéant être montées en parallèle ou en série.

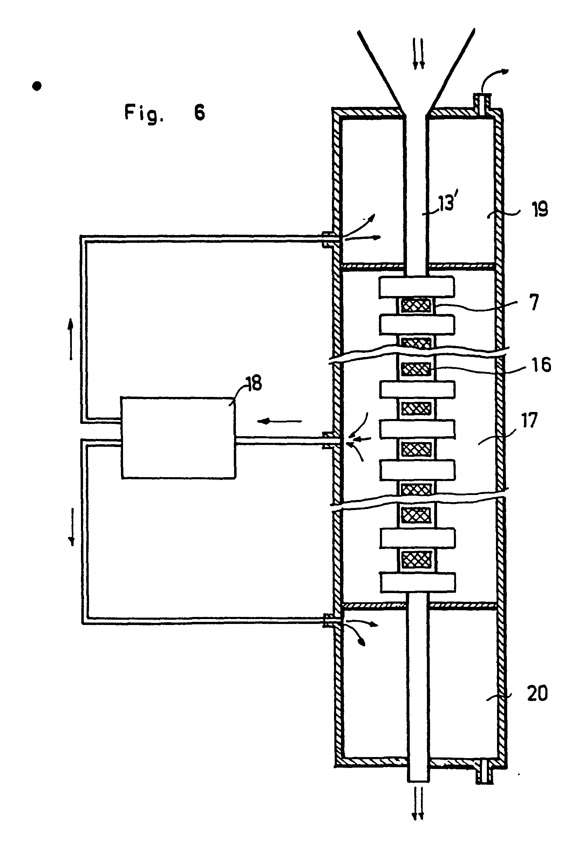

La figure 6 illustre une variante de dispositif dans laquelle les manchons 7' entre cavités sont ajourés sur une portion de leur surface et dotée d'une grille métallique 16 perméable aux gaz et étanche aux micro-ondes pour éviter toute fuite. Le tube interne 13' est alors réalisé à un matériau perméable aux gaz tel que matériau maillé ou poreux, transparent aux micro-ondes. Les cavités résonnantes sont logées dans une enceinte d'aspiration 17 qui permet de récupérer l'air chaud (air chaud chargé, et air chaud provenant des générateurs et de leur alimentation) au moyen d'un système d'aspiration et de refoulement 18 (éventuellement associé à un traitement: dessication . . .). Cet air peut par exemple servir à chauffer le produit soit dans une chambre de préchauffage 19 dans laquelle le tube 13' passe avant d'être soumis au traitement micro-onde, soit dans une chambre de finition 20 dans laquelle le tube 13' passe après traitement en vue d'une étape finale de séchage.

Bien entendu, le produit peut être acheminé par des moyens pneumatiques ou autres, vers une autre colonne afin de subir plusieurs traitements successifs.

## Revendications

1. Dispositif modulaire pour l'application de micro-ondes en vue du traitement d'un matériau, comprenant plusieurs modules alignés en vue de former une colonne de traitement, chaque module constituant une cavité résonnante (1) et comportant deux flasques circulaires en regard (2, 3) en un matériau électriquement conducteur, des ouvertures centrales (2a, 3a) ménagées en regard dans lesdits flasques pour le passage du matériau à traiter, une paroi sensiblement cylindrique (4) en un matériau électriquement conducteur reliant ces flasques de façon à former une boîte fermée de diamètre interne D, une lumière (4a) ménagée dans ladite paroi cylindrique en vue de l'alimentation de la cavité en micro-ondes, et un tronçon externe de guide d'ondes (5), couplé à la cavité résonnante au niveau de ladite lumière (4a) et adapté pour être relié à une source de micro-ondes de fréquence F prédéterminée correspondant à une longueur d'onde λ dans le vide, ledit dispositif étant caractérisé en ce que:

la cavité résonnante est dimensionnée de façon à résonner dans le vide selon le mode $TM_{020}$, son diamètre D exprimé en centimètres étant sensiblement compris entre

$$\frac{50}{F} \quad et \quad \frac{75}{F},$$

où F est exprimé en gigahertz,

les ouvertures (2a, 3a) des flasques sont dimensionnées de façon que soit conservée sensiblement la distribution du champ électrique précitée, le diamètre -d- de chacune desdites ouvertures étant tel que le bord circulaire de chaque ouverture coïncide approximativement avec un noeud du champ électrique en cours de fonctionnement,

les modules sont extérieurement munis de manchons d'assemblage (7) situés autour des ouvertures (2a, 3a) de leurs flasques, lesdits manchons étant adaptés pour permettre d'assujettir lesdits modules les uns aux autres avec un écartement propre à assurer un découplage entre cavités résonnantes voisines en cours de fonctionnement.

2. Dispositif modulaire selon la revendication 1, caractérisé en ce que les manchons d'assemblage (7) sont agencés de façon à permettre d'assujettir deux modules voisins dans plusieurs positions angulaires l'un par rapport à l'autre.

3. Dispositif modulaire selon l'une des revendications 1 ou 2, caractérisé en ce que chaque module comprend, d'une part, sur l'un de ses flasques (3), autour de l'ouverture correspondante (3a), un manchon externe (7) muni d'une bride d'assemblage (8), d'autre part, sur l'autre flasque (2), autour de l'ouverture correspondante (2a), des moyens d'assemblage (9) aptes à coopérer avec la bride du module voisin.

4. Dispositif selon l'une des revendications 1, 2 ou 3, caractérisé en ce que la longueur des manchons d'assemblage (7) est au moins égale à $\lambda/4$.

5. Dispositif selon l'une des revendications 1, 2, 3 ou 4, dans lequel le tronçon de guide d'ondes (5) est du type possédant une longueur d'onde de coupure voisine de la longueur d'onde guidée qu'il propage, caractérisé en ce que le diamètre -d- de chacune des ouvertures (2a, 3a) est égal, à $\mp 10\%$ près, à: $D - 1,4\lambda$.

6. Dispositif selon la revendication 5, dans lequel le tronçon de guide d'ondes (5) est de section rectangulaire adaptée à la longueur d'onde $\lambda$, caractérisé en ce que la lumière (4a) de la paroi cylindrique présente une forme correspondant à ladite section du tronçon de guide d'ondes (5) de façon que celui-ci s'ouvre directement dans la cavité résonnante sensiblement par toute sa section, la hauteur (h) de ladite cavité étant au moins égale à la hauteur de la section dudit tronçon (5).

7. Dispositif modulaire selon l'une des revendications 1, 2, 3, 4, 5 ou 6, pour le traitement d'un matériau se présentant sous forme divisée ou liquide, comprenant un tube de circulation du matériau (13), transparent aux micro-ondes et passant à travers les ouvertures (2a, 3a) pour s'étendre sur toute la hauteur de la colonne de traitement formée par les modules.

8. Dispositif modulaire selon la revendication 7, dans lequel la colonne formée par les modules est disposée le long d'un axe très approximativement vertical en vue d'autoriser une circulation par gravité du matériau dans le tube de circulation (13).

9. Dispositif modulaire selon l'une des revendications 1, 2, 3, 4, 5, 6, 7 ou 8, dans lequel chaque tronçon de guide d'ondes (5) est doté d'une bride (6) en vue de sa liaison à une source de micro-ondes (10, 11) de puissance et/ou de débit réglable.

10. Application du dispositif modulaire conforme à l'une des revendications précédentes pour le chauffage, le séchage ou la torréfaction d'un matériau réactif aux micro-ondes.

**Patentansprüche**

1. Modulare Vorrichtung zur Verwendung von Mikrowellen zwecks Behandlung eines Materials, umfassend mehrere Module, die so ausgerichtet sind, daß sie eine Behandlungssäule bilden, wobei jeder Modul einen Resonanzhohlraum (1) mit zwei einander gegenüberliegenden kreisförmigen Endplatten (2, 3) aus einem elektrisch leitenden Werkstoff bildet, wobei in den besagten Endplatten für den Durchgang des zu behandelnden Materials einander gegenüber Mittelöffnungen (2a, 3a) vorgesehen sind, einer im wesentlichen zylindrischen Wand (4) aus einem elektrisch leitenden Werkstoff, die die besagten Endplatten so verbindet, daß ein geschlossener Kasten mit dem Innendurchmesser D gebildet wird, wobei in der besagten zylindrischen Wand zwecks Speisung des Hohlraums mit Mikrowellen eine Öffnung (4a) vorgesehen ist, und einem äußeren Wellenleiterabschnitt (5), der im Bereiche der besagten Öffnung (4a) mit dem resonanten Hohlraum gekoppelt und so beschaffen ist, daß er mit einer Quelle von Mikrowellen verbunden wird, deren vorbestimmte Frequenz F einer Wellenlänge $\lambda$ im Vakuum entspricht, wobei die besagte Vorrichtung dadurch gekennzeichnet ist, daß

der resonante Hohlraum so bemessen ist, daß er im Vakuum im Einklang mit der Betriebsart $TM_{020}$ resoniert, wobei sein in Zentimetern ausgedrückter Durchmesser D im wesentlichen zwischen

$$\frac{50}{F} \quad \text{und} \quad \frac{75}{F}$$

liegt, wobei F in Gigahertz ausgedrückt wird, die Öffnungen (2a, 3a) der Endplatten so bemessen sind, daß die besagte Verteilung des elektrischen Feldes im wesentlichen gewahrt wird, wobei Durchmesser -d- jeder der besagten Öffnungen so beschaffen ist, daß der kreisförmige Rand jeder Öffnung während des Betriebs annähernd mit einem Knoten des elektrischen Felds übereinstimmt,

die Module an der Außenseite mit rings um Öffnungen (2a, 3a) ihrer Endplatten gelegenen Montagemuffen (7) versehen sind, wobei die besagten Muffen so beschaffen sind, daß die besagten Module aneinander befestigt werden können, und zwar mit einem Abstand, der so beschaffen ist, daß er während des Betriebs Entkoppelung zwischen benachbarten resonanten Hohlräumen gewährleistet.

2. Modulare Vorrichtung nach Anspruch 1, dadurch gekennzeichnet, daß die Montagemuffen (7) so beschaffen sind, daß sie die Anbringung von zwei benachbarten Modulen in mehreren Winkellagen im Verhältnis zueinander gestatten.

3. Modulare Vorrichtung nach einem der Ansprüche 1 oder 2, dadurch gekennzeichnet, daß jeder Modul einerseits an einer seiner Endplatten (3) rings um die entsprechende Öffnung (3a) eine externe Muffe (7) mit einem Montageflansch (8) umfaßt, und andererseits an der anderen Endplatte (2) rings um die entsprechende Öffnung (2a) Montagemittel (9), die so beschaffen sind, daß sie mit dem Flansch des benachbarten Moduls zusammenarbeiten.

4. Vorrichtung nach einem der Ansprüche 1, 2 oder 3, dadurch gekennzeichnet, daß die Länge der Montagemuffen (7) mindestens $\lambda/4$ entspricht.

5. Vorrichtung nach einem der Ansprüche 1, 2, 3 oder 4, bei der Wellenleiterabschnitt (5) der Art ist, bei der die kritische Wellenlänge annähernd der Länge der von ihm propagierten geleiteten Welle gleich ist, dadurch gekennzeichnet, daß Durchmesser -d- jeder der Öffnungen (2a, 3a) innerhalb von ∓10% D−1,4λ entspricht.

6. Vorrichtung nach Anspruch 5, bei der Wellenleiterabschnitt (5) einen rechteckigen Querschnitt im Einklang mit Wellenlänge λ aufweist, dadurch gekennzeichnet, daß Öffnung (4a) in der zylindrischen Wand eine Form hat, die dem besagten Querschnitt des Wellenleiterabschnitts (5) entspricht, so daß dieser im wesentlichen über seinen gesamten Querschnitt hinweg unmittelbar in den resonanten Hohlraum mündet, wobei Höhe (h) des besagten Hohlraums der Höhe des Querschnitts des besagten Abschnitts (5) mindestens gleich ist.

7. Modulare Vorrichtung nach einem der Ansprüche 1, 2, 3, 4, 5 oder 6 für die Behandlung eines teilchenförmigen oder flüssigen Materials, umfassend eine Materialumlaufröhre (13), die Mikrowellen gegenüber durchlässig ist und durch die Öffnungen (2a, 3a) hindurch verläuft, so daß sie sich über die gesamte Höhe der durch die Module gebildeten Behandlungssäule erstreckt.

8. Modulare Vorrichtung nach Anspruch 7, bei der die durch die Module gebildete Säule entlang einer sehr annähernd senkrechten Achse angeordnet ist, so daß sie schwerebedingten Umlauf des in Umlaufröhre (13) befindlichen Materials gestattet.

9. Modulare Vorrichtung nach einem der Ansprüche 1, 2, 3, 4, 5, 6, 7 oder 8, bei der jeder Wellenleiterabschnitt (5) zwecks Anschluß an eine Mikrowellenquelle (10, 11) regelbarer Leistung und/oder regelbaren Ausgangs mit einem Flansch (6) versehen ist.

10. Einsatz der modularen Vorrichtung nach einem der vorstehenden Ansprüche zum Erhitzen, Trocknen oder Rösten eines auf die Mikrowellen reagierenden Materials.

**Claims**

1. Modular device for the use of microwaves with a view to processing a material, comprising several modules aligned so as to form a processing column, whereby each module constitutes a resonant cavity (1) comprising two opposite circular end plates (2, 3) made from an electrically conductive material, central openings (2a, 3a) being provided opposite one another in said end plates for the passage of the material to be processed, a substantially cylindrical wall (4) made from an electrically conductive material connecting said end plates so as to form an enclosed box with an internal diameter D, an aperture (4a) being provided in said cylindrical wall with a view to supplying the cavity with microwaves, and an external wave guide section (5), connected with the resonant cavity at the point of said aperture (4a) and so designed as to be connected with a source of microwaves at a predetermined frequency F corresponding to a wavelength λ in vacuum, the said device being characterised in that the resonant cavity is so dimensioned as to resonate in vacuum according to mode $TM_{020}$, its diameter D expressed in centimetres being substantially comprised between

$$\frac{50}{F} \text{ and } \frac{75}{F},$$

where F is expressed in gigahertz,

openings (2a, 3a) of the end plates are so dimensioned as to substantially maintain said distribution of the electric field, diameter -d- of each of said openings being such that, during operation, the circular edge of each opening coincides approximately with a node of the electric field,

the modules are provided, on the outside, with assembly sleeves (7) situated about openings (2a, 3a) of their end plates, said sleeves being so designed as to enable the said modules to be secured to one another subject to a spacing appropriate for ensuring that, during operation, adjacent resonant cavities are decoupled.

2. Modular device according to claim 1, characterised in that assembly sleeves (7) are so designed as to enable two adjacent modules to be connected in several angular positions in relation to one another.

3. Modular device according to one of claims 1 or 2, characterised in that each module comprises, on the one hand, on one of its end plates (3) about the corresponding opening (3a), an outer sleeve (7) provided with an assembly flange (8), and on the other hand, on the other end plate (2) about the corresponding opening (2a), assembly means (9) so designed as to cooperate with the flange of the adjacent module.

4. Device according to one of claims 1, 2 or 3, characterised in that the length of assembly sleeves (7) is at least equal to λ/4.

5. Device according to claims 1, 2, 3 or 4, in which wave guide section (5) is of the type having a cut-off wavelength close to the length of the guided wave which it propagates, characterised in that diameter -d- of each opening (2a, 3a) is equal, within ∓10%, to D−1.4λ.

6. Device according to claim 5, in which wave guide section (5) has a rectangular cross-section in accordance with wavelength λ, characterised in that aperture (4a) in the cylindrical wall has a shape corresponding to said cross-section of wave guide section (5), so that the latter opens out directly into the resonant cavity, substantially over its entire cross-section, height (h) of said cavity being at least equal to the height of the cross-section of said section (5).

7. Modular device according to one of claims 1, 2, 3, 4, 5 or 6 for processing a material in particulate or liquid form, whereby said device comprises a material circulation tube (13), which is transparent to the microwaves and passes through openings (2a, 3a) so as to extend throughout the entire height of the processing column formed by the modules.

8. Modular device according to claim 7, in which the column formed by the modules is arranged along a very approximately vertical axis with a view to enabling circulation by gravity of the material within circulation tube (13).

9. Modular device according to one of claims 1, 2, 3, 4, 5, 6, 7 or 8, in which each wave guide section (5) is provided with a flange (6) with a view to connecting it to a microwave source (10, 11) of controllable power and/or output.

10. Application of the modular device according to one of the preceding claims for heating, drying or torrefying a material which reacts to the microwaves.

Fig. 1

Fig. 2

Fig. 3

Fig. 4

Fig. 5a

Fig. 5b

$TM_{020}$

Champs électriques
suivant X X'

$TM_{120}$
ou $TM_{220}$

Fig.   6

13'

19

7

16

17

18

20